Europäisches Patentamt

European Patent Office

Office européen des brevets

(19)

(11) Veröffentlichungsnummer: **0 146 645**
**B1**

(12) **EUROPÄISCHE PATENTSCHRIFT**

(45) Veröffentlichungstag der Patentschrift:
16.09.87

(21) Anmeldenummer: 83112339.3

(22) Anmeldetag: 08.12.83

(51) Int. Cl.⁴: **G 06 F 11/26,** H 03 M 9/00,
G 11 C 19/00

(54) Prüf- und Diagnoseeinrichtung für Digitalrechner.

(43) Veröffentlichungstag der Anmeldung:
03.07.85 Patentblatt 85/27

(45) Bekanntmachung des Hinweises auf die Patenterteilung:
16.09.87 Patentblatt 87/38

(84) Benannte Vertragsstaaten:
DE FR GB

(56) Entgegenhaltungen:
DE - A - 2 625 183
US - A - 3 760 382
US - A - 4 183 461
US - A - 4 322 812

(73) Patentinhaber: **IBM DEUTSCHLAND GMBH,
Pascalstrasse 100, D-7000 Stuttgart 80 (DE)**

(84) Benannte Vertragsstaaten: **DE**

(73) Patentinhaber: **International Business Machines
Corporation, Old Orchard Road, Armonk,
N.Y. 10504 (US)**

(84) Benannte Vertragsstaaten: **FR GB**

(72) Erfinder: **Blum, Arnold, Finkenweg 16, D-7621 Gechingen
(DE)**

(74) Vertreter: **Jost, Ottokarl, Dipl.-Ing., Schönaicher
Strasse 220, D-7030 Böblingen (DE)**

EP 0 146 645 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft eine Einrichtung zur Fehlerprüfung und -diagnose für eine elektronische Datenverarbeitungsanlage, die aus mindestens einem Prozessor, einem Hauptspeicher und einem Wartungs- und Bedienungsprozessor besteht, die über einen schnellen Systembus miteinander verbunden sind.

Das Testen von hochverdichteten Logik- und Speicherschaltkreisen auf Chips, aus denen elektronische Steuerungen, Prozessoren und andere Datenverarbeitungseinrichtungen aufgebaut sind, beruht sehr wesentlich auf der Zugänglichkeit (Beobachtbarkeit, Einstellbarkeit) der Gesamtheit aller Speicherelemente (bistabile Schalter, Flipflops) auf dem Chip. Gerade hier aber ergeben sich Probleme, weil die digitalen Systeme einer sehr hohen Fehlerabdeckung bedürfen und die Prüfung der hochverdichteten Schaltkreisstrukturen einen hohen Zeit- und Kostenaufwand erfordert, wegen der Schaltkreisdichte dieser VLSI-Chips (VLSI = Very Large Scale Integration). Die Verarbeitungseinheiten, beispielsweise Mikroprozessoren, bestehen aus oder enthalten sehr komplizierte Chips, die in einer Weise geprüft werden müssen, die die hohe Anzahl von Zuständen berücksichtigt, welche die bistabilen Speicherelemente einnehmen können und die auch die sogar noch grössere Anzahl von Zustandsfolgen miteinbezieht, welche die genannten Speicherelemente eines Prozessors während der Ausführung von Programmroutinen einnehmen können.

Betrachtet man eine Mikroinstruktion als eine endliche funktionale Grösse, dann ist die Überprüfung der im allgemeinen wohl spezifizierten und definierten Funktionen einer Mikroinstruktion, wie beispielsweise die Einstellung der Zustandsspeicherstellen einer arithmetischen und logischen Einheit /ALU), nach der Ausführung einer Additions-Mikroinstruktion ein überschaubares Problem. Schwierigkeiten treten jedoch dann auf, wenn auch alle möglichen Seitenfunktionen dieser Additions-Mikroinstruktion getestet werden sollen, wie beispielsweise die Veränderung oder Nichtveränderung des Zustandes eines bistabilen Speicherelementes, das Busanforderungen während der Ausführung einer solchen Additions-Mikroinstruktion indiziert.

Im allgemeinen benötigen die Seitenfunktionen eine grosse Anzahl von Speicherelementen, die dem Datenfluss und der Steuerlogik des Prozessors zugeordnet sind. Diese Speicherelemente können im allgemeinen nicht direkt für Testzwecke erreicht werden, selbst durch besondere Mikroinstruktionen nicht, ohne dabei die momentan herrschende Zustandssituation aller Speicherelemente, die der Zustandsanzeige dienen, zu verändern.

Hochverdichtete Logikstrukturen und Systemarchitekturen, die prüfbar sein sollen, machen oft von sog. LSSD-Entwurfsregeln (LSSD = Level Sensitive Scan Design) Gebrauch, nach denen beispielsweise ein Logik-Subsystem signalpegelsensitiv ist, wenn — und nur dann — die Antwort im eingeschwungenen Zustand auf eine Eingangssignaländerung von Schaltkreis- und Leitungsverzögerungen innerhalb des Logik-Subsystems unabhängig ist (vgl. «A logik Design Structure for LSI Testability» von E.B.

Eichelberger — Proceedings of the Design Automation Conference, No. 14, 20. bis 22. Juni 1977, New Orleans, Louisiana, Seiten 462-468).

Basierend auf diesen LSSD-Entwurfsregeln wird die Beobachtbarkeit und Einstellbarkeit der Gesamtheit aller Speicherelemente dadurch ermöglicht, dass die einen Bestandteil der Logik bildenden und auch zwischen den Logikstufen angeordneten Master-Slave-Flipflops im Testbetrieb zu einer oder mehreren Schieberegisterketten zusammenschaltbar sind, über die Prüfmuster in die Tiefe der Logik hineingeschoben und Ergebnismuster herausgeschoben werden.

Über diese Schieberegisterketten ist es auch möglich, vollständige Flipflop- oder Registerstatusinformation komplexer und hinsichtlich ihrer Packung abgegrenzter Logikstufen, wie beispielsweise ein Chip oder ein Modul, hinein- und/oder herauszuschieben. Diese Schieberegisterlösung hat den Vorteil, dass nur relativ wenig Ein/Ausgangsanschlüsse erforderlich sind und eine hochgradige Flexibilität zwischen allen Packungsstufen erreicht werden kann, wenn alle ersten Packungsstufen-Schieberegisterketten mit einer gemeinsamen zweiten Packungsstufen-Schieberigisterkette usw. verbunden wird, ohne dass dabei der logische Entwurf innerhalb der Chips beeinflusst wird.

Da die Speicherelemente eines Prozessors fast ausschliesslich aus Schieberegisterstufen bestehen, kann die Überprüfung der Seitenfunktionen entweder von einem integrierten Wartungs- und Bedienungsprozessor oder von einem anschliessbaren separaten Tester vorgenommen werden, indem der Inhalt der bistabilen Speicherelemente, die für die Prüfung zu Schieberegistern zusammengeschaltet werden, vor und nach der Ausführung der zu überprüfenden Mikroinstruktion in den Wartungs- und Bedienungsprozessor oder den Tester geschoben werden, der den Unterschied der Zustände mit den vorgegebenen Soll-Werten vergleicht.

Eine weitere wesentliche Verbesserung der diagnostischen Fähigkeiten von Mikrobefehlsprüfungen im Daten- und Befehlsaustausch der Verarbeitungseinheiten und Prozessoren untereinander ist dadurch denkbar, dass die Testprozeduren auf noch schmalere funktionelle Grössen angewendet werden, wie beispielsweise die Taktschritte der zu prüfenden Mikroinstruktion. Dadurch könnte die Fehlerprüfabdeckung automatischer Tests erheblich verbessert werden.

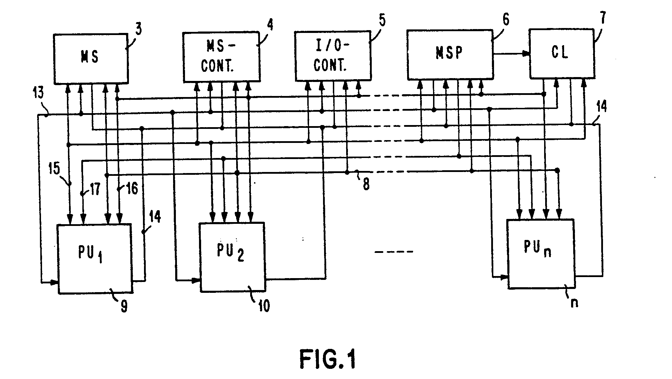

Die vorstehend erwähnten Prüfverfahren erfordern jedoch einen Hochgeschwindigkeitstransport von Zuständen, die in einer sehr grossen Zahl von bistabilen Schaltelementen gespeichert sind, der von einem Wartungs- und Bedienungsprozessor oder einem Fabriktester durchgeführt werden müsste, die dieses aber aufgrund der bekannten langsamen Prüfnetze und des seriellen Verschiebemechanismus nicht ausführen können. Darüber hinaus kann auch die Taktgeschwindigkeit der Verschiebemechanismen trotz der sehr schnellen Technologie der Prozessorchips nicht weiter gesteigert werden, da der Verschiebering zwei langsamere Netze aufweist, von denen sich das eine von dem Prozessor oder der Verarbeitungseinheit zu dem Wartungs- und Bedienungsprozessor und das andere sich vom Wartungs- und Bedienungsprozessor zum Prozessor erstreckt (vgl. Fig. 1, Leitungen 14 und 13).

Häufig enthalten Datenvererbeitungsanlagen für Diagnosezwecke einen eigenen Prüfbus, über den Testdaten über einen Tester zugeführt und die ergebnisdaten verarbeiteter Testdaten wieder zum Tester zum Zweck der Überprüfung zurückübertragen werden. Das in der US-Patentschrift 4 322 812 beschriebene Datenverarbeitungsgerät zählt zu dieser Gerätekategorie, wobei Testdaten und Ergebnisdaten mittels zu Ketten zusammengeschalteten Schieberegistern zugeführt bzw. entnommen werden. Für den Aufbau dieser Schieberegisterketten werden Mehr Bit-Schieberegisterbausteine über Torschaltungen zu längeren Ketten derart verbunden, dass der Ausgang eines Bausteines mit dem Eingang des nächsten Bausteines zusammengeschaltet ist.

Datenverarbeitungssysteme sind jedoch im allgemeinen mit parallelen Hochgeschwindigkeits-Systembussen ausgestattet, welche die verschiedenen Einheiten, wie beispielsweise die Prozessoren 9, 10, ... n, den Hauptspeicher 3, die Hauptspeichersteuerung 4, die Ein-/Ausgabegerätesteuerung 5 und den Wartungs- und Bedienungsprozessor 6, wie Fig. 1 zeigt, miteinander verbinden. Diese Systembusse sind jedoch bei bekannten Datenverarbeitungsanlagen normalerweise für den direkten Zugriff des Wartungs- und Bedienungsprozessors zu den bistabilen Elementen der Prozessoren, welche u.a. auch die Statusinformation enthalten, nicht vorgesehen. Eine Ausnahme bildet hierbei eine Prüf- und Diagnoseeinrichtung für Digitalrechner, die in der Europäischen Patentanmeldung 83 105 172.7 (EP-A-0 126 785) beschrieben ist. Bei dieser Datenverarbeitungsanlage sind die Speicherelemente (Flipflops), die im normalen Betrieb die Logik-Subnetze miteinander verbinden, für den Fehlerprüf- und Diagnosebetrieb zu einer adressierbaren Matrix zusammengeschaltet, so dass der vorgesehene Wartungs- und Bedienungsprozessor sowohl Adresseninformation zur Ansteuerung der einzelnen Speicherelemente der Matrix als auch Testdaten über den schnellen Systembus zum Einspeichern in die Speicherelemente der Matrix sowie Teststeuer- und Taktinformation zu der zu prüfenden Einheit übertragen kann. Ferner werden nach erfolgter Prüfung der Logik-Subnetze deren Ergebnisdaten in die jeweils angeschlossenen Speicherelemente eingegeben und von dort dem Wartungs- und Bedienungsprozessor aus den wieder zu einer Matrix zusammengeschalteten Speicherelementen mittels über den Systembus übertragener Adresseninformation und Steuerinformation ebenfalls über den Systembus übernommen.

Da es sich bei den Speicherelementen der Matrix ausschliesslich um solche Stufen handelt, die aus sogenannten Master-Flipflops aufgebaut sind, ist die übliche Realisierung mit Schieberegistern, die aus Master-Slave-Flipflops aufgebaut sind, nicht möglich, was für viele Entwurfskonzepte von Datenverarbeitungsanlagen sehr nachteilig ist.

Ein weiterer Nachteil bekannter Systeme resultiert aus der Einadrigkeit des Prüfbusses 13, 14, welche die Gefahr in sich birgt, dass Leitungsunterbrechungen zum Totalausfall des Prüfbusses und damit auch der Datenverarveitungsanlage führen, weil im allgemeinen der Wartungs- und Bedienungsprozessor neben der Prüffunktion auch die Bedienungsfunktion des Systems erfüllt, indem er beispielsweise die Konsole des Systems mit Bildschirm und Tastatur steuert.

Die Erfindung hat es sich somit zur Aufgabe gemacht, eine prüfbare Logikstruktur anzugeben, die auch im Prüfbetrieb nach dem LSSD-Prinzip äusserst schnell, zuverlässig und kostengünstig arbeiten kann.

Gelöst wird diese Aufgabe der Erfindung durch die im Hauptanspruch angegebenen Merkmale.

Vorteilhafte Ausgestaltungen und Weiterbildungen des Gegenstandes der Erfindung sind den Unteransprüchen zu entnehmen.

Durch die Erfindung wird somit der Vorteil erzielt, dass im Prüfbetrieb die Prüfmuster und Ergebnisdaten, die über den sehr schnellen Systembus zwischen einem Wartungsprozessor oder Tester und den zu prüfenden Logikstrukturen übertragen werden, sehr schnell in und aus den Schiebeketten zur Verfügung stehen, wobei auch im Fehlerfalle, entweder des Systembusses oder des Prüfbusses, über den jeweils intakten Bus der Prüfbetrieb noch durchführbar ist.

Im folgenden werden einige Ausführungsbeispiele der Erfindung anhand der Figuren näher beschrieben. Es zeigen:

Fig. 1 das Blockschaltbild einer digitalen elektronischen Rechenanlage, in welcher die Erfindung Anwendung findet,

Fig. 2 das Blockschaltbild einer Verarbeitungseinheit, beispielsweise eines Prozessors, einschliesslich der Schaltungsanordnungen, die für einen Testdatenaustausch mit einer zentralen Prüfeinrichtung vorgesehen sind,

Fign. 3 und 4 Zeitdiagramme zur Veranschaulichung des Testdatenaustausches,

Fig. 5 das Blockschaltbild einer Verarbeitungseinheit mit modifizierten Schaltungsanordnungen für den Testdatenaustausch,

Fig. 6 ein Zeitdiagramm zur Veranschaulichung des Testdatenaustausches im Zusammenhang mit einer Verarbeitungseinheit nach Fig. 5,

Fig. 7 das Blockschaltbild einer weiteren Modifizierung der Schaltungsanordnungen für den Testdatenaustausch in einer Verarbeitungseinheit und

Fig. 8 ein Zeitdiagramm zur Veranschaulichung des Datenaustausches im Zusammenhang mit einer Verarbeitungseinheit nach Fig. 7.

Fig. 1 zeigt das Blockschaltbild einer modular aufgebauten Datenverarbeitungsanlage, die über Ein-Chip-Verarbeitungseinheiten oder -prozessoren (PU1 bis PUn) 9 bis n verfügt, die über einen (standardisierten) Systembus 8 sowohl miteinander als auch mit einem Hauptspeicher (MS) 3, einer Hauptspeicher-Steuereinheit (MS-CONT) 4, einer Ein-/Ausgabegerätesteuerung (I/O-CONT) 5 und einem Wartungs- und Bedienungsprozessor (MSP) 6 verbunden sind. Es existieren ferner Verbindungen 13 bis 17 zwischen den oben aufgeführten Systemkomponenten einerseits und dem Wartungs- und Bedienungsprozessor 6 andererseits, über die Steuer- und Taktsignale sowie Test- oder Prüfdaten übertragen werden. Unter den genannten Leitungen befindet sich ferner eine Taktleitung 15, die eine Verbindung der Systemkomponenten zu einem Takterzeuger (CL) 7 herstellen, der, wie Fig. 1 zeigt, ebanfalls mit dem Wartungs- und Bedienungsprozessor 6 verbunden ist. Anstelle eines zentralen Takterzeugers, wie der Takterzeuger 7, können die Systemkomponenten, insbesondere die Prozessoren 9 bis n, auch über individuelle Takterzeuger auf ihren jeweiligen Chips verfügen.

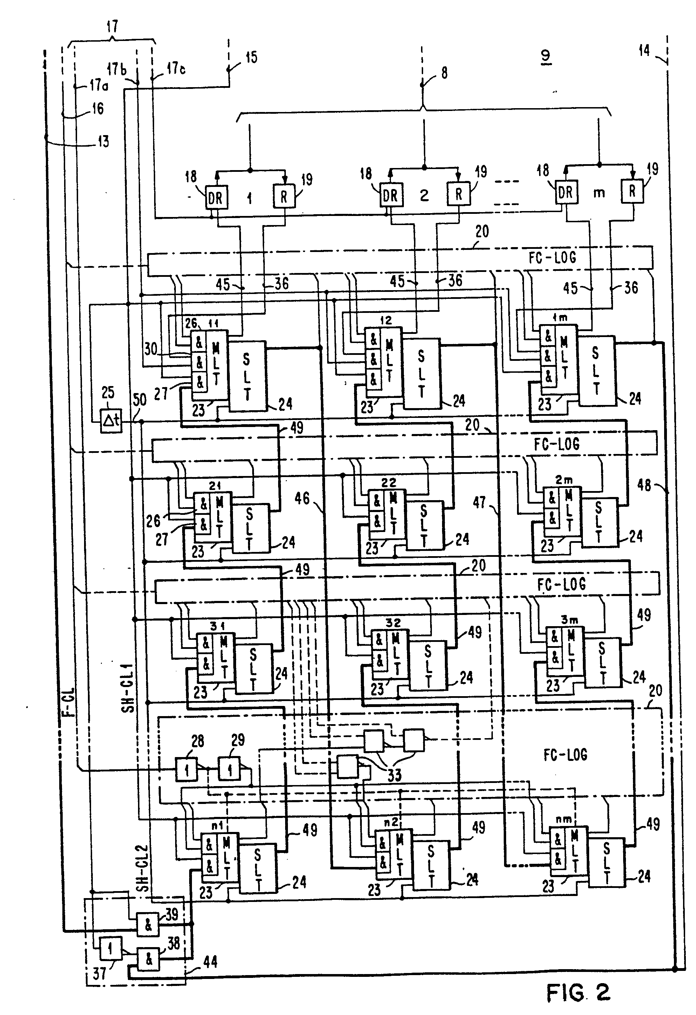

Die Erfindung wird im folgenden im Zusammenhang mit dem nach den Prinzipien der Höchstintegrationstechnik aufgebauten Prozessor 9 erläutert. Der Systembus 8, der beispielsweise ein standardisierter Bus sein kann, möge im vorliegenden Ausführungsbeispiel eine Breite von 4 Bytes aufweisen. An diese Breite sind sowohl die Bus-Senderschaltungen (DR) 18, als auch die Bus-Empfängerschaltungen (R) 19 angepasst (Fign. 2, 5 und 7).

Die Speicherelemente 23, 24, meistens sog. Polarity Hold Flipflops, sind gemäss den eingangs erwähnten LSSD-Entwurfsregeln als Master-Slave-Flipflops ausgelegt, die im Prüf- oder Testbetrieb zu Schieberegisterketten zusammengefasst werden.

Fig. 2 zeigt links unten an der Position n1 die Eingangsstufe einer Schieberegisterkette, die über einen Schalter 44, bestehend aus einem Inverter 37 und zwei UND-Toren 38 und 39, über die Leitung 13 des Prüfbusses mit dem Wartungs- und Bedienungsprozessor 6 verbunden ist. Die Kette setzt sich dann mit Schieberegisterstufen in der Reihenfolge der Positionen 31, 21, 11, n2, 32, 22, 12, ..., nm, 3m, 2m und 1m fort, wobei der Ausgang des Slave-Flipflops (SLT) an der Position 1m über die Leitung 14 des Prüfbusses mit dem Wartungs- und Bedienungsprozessor 6 sowie über den Schalter 44 mit dem Master-Flipflop (MLT) der Eingangsstufe n1 verbunden ist. Auf diese Weise ergibt sich eine Verbindung zwischen dem Wartungs- und Bedienungsprozessor 6 und der zu prüfenden Verarbeitungseinheit, beispielsweise dem Prozessor 9.

Der bereits erwähnte Schalter 44 hat die Aufgabe, den Ausgang der Schieberegisterkette mit ihrem Eingang zu verbinden, so dass die in den Schieberegisterstufen gespeicherten Informationsinhalte in der Schieberegisterkette selbst schrittweise von Stufe zu Stufe zirkulieren können.

Bei bekannten Datenverarbeitungsanlagen werden die Testdaten oder Prüfmuster seriell über die Leitung 13 vom Bedienungs- und Wartungsprozessor 6 in die Schieberegisterkette hineingeschoben, und zwar mit Hilfe eines Schiebetaktes, der über eine Test-Schiebetaktleitung 15 vom Wartungs- und Bedienungsprozessor 6 an die zu prüfende Verarbeitungseinheit angelegt wird. Dieser Schiebetakt, der in den Figuren mit SH-CL1 bezeichnet wird, und dem zeitlich zuerst zugeführten Takt einer Schieberegisterstufe entspricht, und der die Übernahme der Daten in den Master-Flipflop 23 steuert, wird auf dem Chip in einem Verzögerungsglied 25 um die Zeitspanne Δt verzögert. Der verzögerte Takt, der mit SH-CL2 bezeichnet ist, entspricht dem zweiten Schiebetakt einer Schieberegisterstufe, der die Datenübernahme des Slave-Flipflop (SLT) aus dem vorhergehenden Master-Flipflop steuert.

Die Testdaten werden normalerweise über die Leitung 13 in die Schieberegisterkette hineingeschoben. Nach erfolgter Übernahme der Testdaten in die einzelnen Schieberegisterstufen werden diese Testdaten den zu prüfenden Logik-Subnetzen 20 zugeführt. Diese Logik-Subnetze 20 sind im allgemeinen aus Logikstufen 33 der verschiedensten Art, z.B. NAND, NOR, INVERTERN, EXKLUSIV-ODER und dgl. aufgebaut. Die Verarbeitung der Testdaten in den Logik-Subnetzen wird durch Funktionstaktsignale F-CL gesteuert, die entweder von dem zentralen Taktgeber 7 über die Leitung 16 zu dem Prozessor 9 übertragen oder aber alternativ von einem (nicht dargestellten) prozessoreigenen Taktgeber erzeugt werden.

Die Antwort der Logik-Subnetze 20 auf die Testdaten, also die Ergebnisdaten, werden danach von den Schieberegisterstufen übernommen und mit den Schiebetakten SH-CL1 und SH-CL2 über die Leitung 14 in den Wartungs- und Bedienungsprozessor 6, zwecks Fehleranalyse und/oder -diagnose, hineingeschoben.

Da dieses serielle Übertragungsverfahren für die grossen Testdatenmengen, die benötigt werden, um Datenverarbeitungseinrichtungen bis in die Tiefe ihrer Logikstruktur zu prüfen, zu langsam ist, wird diese Übertragung über den schnellen, hitparallelen Systembus 8 vorgenommen. Damit entsteht aber das Problem, in Empfangsrichtung des zu prüfenden Prozessors die Testdaten aus den Schnittstellenregistern des Systembusses ebenso schnell in die Schieberegisterstufen einzugeben bzw. in Senderichtung die in den Schieberegisterstufen gespeicherten Ergebnisdaten in die Schnittstellenregister zwischen Systembus 8 und der Logik des Prozessors 9 zu bringen.

Wenn man nun die Anordnung der Schieberegisterketten so trifft, dass sich eine girlandenförmige Struktur ergibt, in die auch die Schnittstellen-Registerstufen einbezogen sind, dann ist eine Zugriffsparallelisierung, die der parallele Systembus 8 erfordert, im Test- und Diagnosebetrieb möglich. Eingang und Ausgang der girlandenförmig angeordneten Schieberegisterkette werden über den Schalter 44 zu einem Ring zusammengeschaltet. Dieser Ring besteht aus den Verbindungsleitungen 49, welche die einzelnen Stufen eines Teilgliedes der Girlande, bestehend aus den Schieberegisterstufen an den Positionen n1, 31, 21 und 11 sowie aus Verbindungsleitungen 46, 47 und 48, welche die übrigen Teilglieder der Kette miteinander verbinden.

Die erwähnten Stufen des Schnittstellenregisters sind identisch mit den Schieberegisterstufen an den Positionen 11, 12, ..., 1m. Die schnelle Übernahme von Daten aus dem Wartungs- und Bedienungsprozessor oder einem an den Systembus 8 und an die Steuerleitungen 15 bis 17 angeschlossenen Fabriktester erfolgt über die Busempfängerschaltungen 19, die Verbindungsleitungen 36 und die Eingangstore 30 der jeweiligen Master-Flipflops 23 der Schnittstellen-Registerstufen. Ein Steuersignal auf der Steuerleitung 17a schaltet den Schalter 44 in den Testbetrieb, in dem die girlandenförmige Schieberegisterkette zu einem Ring zusammengeschaltet ist.

Ferner wird ein Impuls des Schiebetaktes SH-CL1 über die Leitung 15 angelegt, der zu allen Master-Flipflops 23 der Schieberegisterkette übertragen wird. Ausserdem wird dieser Schiebeimpuls auch zu dem Verzögerungsglied 25 übertragen, das einen Impuls des Schiebetaktes SH-CL2 erzeugt, das an alle Slave-Flipflops 24 der Schieberegisterkette angelegt wird. Erforderlich ist ferner ein Steuerimpuls auf der Steuerleitung 17b, der die bereits erwähnten Eingangstore 30 der Master-Flipflops 23 der Schnittstellen-Registerstufen durchschaltet, damit die Daten zeitgerecht vom Systembus übernommen werden können.

Damit ist ein erster Verschiebeschritt durchgeführt, so dass im nächsten Verschiebeschritt über die Master-Flipflops 23 des Schnittstellenregisters neue Daten übernommen werden können. Die Daten aus dem vorhergehenden Übertragungsschritt gelangen nun über die Verbindungsleitungen 46, 47 und 48 aus den Slave-Flipflops 24 in die Master-Flipflops der folgenden Schieberegisterstufen an den Positionen n1, n2, ... nm.

Auf diese Weise kann die Schieberegisterkette wesentlich schneller mit Daten beschickt werden, als dieses im reinen seriellen Betrieb möglich wäre. Ausserdem können auf dem VLSI-Chip (VLSI = Very Large Scale Integration) selbst wesentlich schnellere Verschiebetakte von einer einzigen hochfrequenten Impulsfolge erzeugt werden, als diejenige, die vom Wartungs- und Bedienungsprozessor 6 zu dem Prozessorchip übertragen wird. Auf diese Weise werden auch die üblichen Taktverzerrungen vermieden, welche die Impulsfrequenz der Verschiebetakte SH-CL1 und SH-CL2 beschränken würden, ohne ihnen eine Überlappung zu gestatten oder nicht genügend Zeit für den schlechtesten Fall der Signallaufzeit zwischen zwei benachbarten Schieberegisterstufen längs der Schieberegisterkette zur Verfügung zu stellen. Dadurch, dass sich nun die gesamte Schieberegisterkette auf dem VLSI-Chip befindet, ohne dass sie dieses verlassen muss, kann auch die Impulsfrequenz der Schiebetakte wesentlich höher gewählt werden.

Wegen der girlandenförmigen Struktur der Schieberegisterkette und der Einbeziehung der Stufen des Schnittstellenregisters in die Schieberegisterkette sowie der schrittweisen Erzeugung der Impulse für den Verschiebetakt SH-CL1 und für den Verschiebetakt SH-CL2, die beide von einem einzigen externen Taktimpuls erzeugt werden, der dem Prozessorchip 9 zugeführt wird, kann der Inhalt aller Schnittstellen-Registerstufen mit neuer Information aufgefüllt werden.

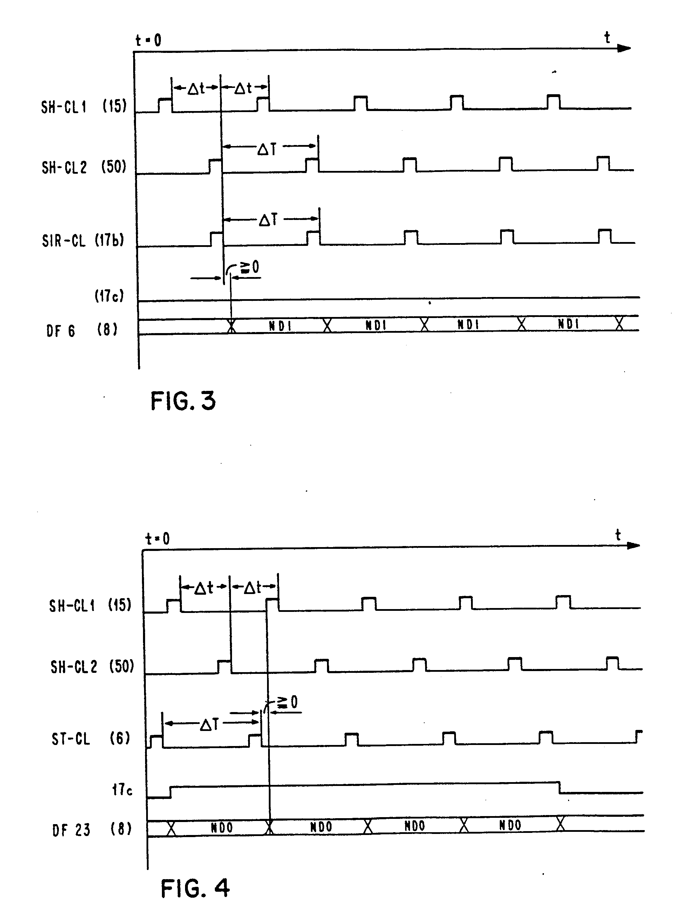

Die hierbei auftretenden zeitlichen Vorgänge sind ausführlich in Fig. 3 dargestellt. Die zweite Zeile in Fig. 3 zeigt die über die Leitung 15 vom Wartungs- und Bedienungsprozessor 6 oder Tester übertragene Taktimpulsfolge SH-CL1. Mit einem zeitlichen Abstand $\Delta t$ erscheint dann auf der Leitung 50 der von dem Verzögerungsglied 25 erzeugte Schiebetakt SH-CL2.

Wenn angenommen wird, dass die grösstmögliche Laufzeitverzögerung $\Delta T$ eines Taktnetzes, welches die Prozessorchipgrenzen überschreitet, zweimal so gross ist, wie die grösstmögliche Laufzeitverzögerung $\Delta t$ des Taktnetzes, das ausschliesslich auf dem Prozessorchip verläuft, dann können für den Verschiebevorgang für die Test- und Ergebnisdaten mehrere Möglichkeiten der Verschiebetaktgabe in Betracht gezogen werden. Von einem einzigen externen Taktimpuls werden auf dem Chip die Verschiebetakte SH-CL1 und SH-CL2 erzeugt. Danach wird mit einem Takt SIR-CL, der über die Steuerleitung 17b vom Wartungs- und Bedienungsprozessor 6 oder einem angeschlossenen Tester zum Prozessor 9 übertragen wird, die Eingangsstufe 30 der Master-Flipflops der Schnittstellen-Registerstufen aufgesteuert, so dass die Testdaten über die Leitungen des Systembusses 8 in das Schnittstellenregister gelangen. Dieser Vorgang ist in Fig. 3 in der letzten Zeile dargestellt, wo zu erkennen ist, dass die jeweils nächsten Testdaten NDI unmittelbar mit einem Impuls des Taktes SIR-CL in den Schnittstellenregistern übernommen werden. Die Bezeichnung DF 6 (Data From 6) dieser letzten Zeile in Fig. 3 soll zum Ausdruck bringen, dass der Wartungs- und Bedienungsprozessor 6 die Quelle dieser Daten ist. Die Steuerleitung 17c kann bei der Übertragung von Ergebnisdaten aus dem Prozessor 9 auf den Systembus 8 inaktiv bleiben, da die Bus-Senderschaltungen nicht benötigt werden (vgl. Fig. 3, vorletzte Zeile).

Die Testdatenübertragungen vom Wartungs- und Bedienungsprozessor über den Systembus 8 sind, wie Fig. 3 erkennen lässt, mit den internen Verschiebeschritten überlappt, so dass bei einem 32 Bit breiten Systembus die für den Zugriff zu einer Schieberegisterstufe erforderliche Zeit 64 mal kürzer ist, als die Zeit, die für den Zugriff zu einer konventionell nach den LSSD-Entwurfsregeln betriebenen Schieberegisterstufe benötigt würde.

Die Ergebnisdaten, die nach jedem Prüfschritt in den Schieberegisterstufen für eine Übertragung zum Wartungs- und Bedienungsprozessor 6 zwecks Fehlerprüfung und/oder -diagnose bereitstehen, werden in analoger Weise vom Ausgang der Master-Flipflops 23 des Schnittstellenregisters über die Leitungen 45, die Bus-Senderschaltungen 18 und den Systembus 8 in den Wartungs- und Bedienungsprozessor 6 übertragen. Der jeweilige Sendezeitpunkt wird durch ein Signal auf der Steuerleitung 17c bestimmt, das beispielsweise vom Wartungs- und Bedienungsprozessor erzeugt wird und die Bus-Senderschaltungen 18 aktiviert. Zuvor gelangen die Ergebnisdaten der Logik-Subnetze 20 über die Eingangsstufen 26 in die Master-Flipflops 23. Handelt es sich aber um die übrigen Schieberegisterstufen — also nicht die Stufen des Schnittstellenregisters —, dann gelangen die Ergebnisdaten der Logik-Subnetze vom Master-Flipflop 23, beispielsweise der Schieberegisterstufe in der Position 21, zum zugeordneten Slave-Flipflop 24 und über die Leitung 49 zum Eingang 27 der jeweils nachfolgenden Schieberegisterstufe, bis sie auf diese Weise in eine Stufe des Schnittstellenregisters gelangen, von wo aus sie den zuvor beschriebenen Weg zum Wartungs- und Bedienungsprozessor nehmen.

Das Zeitdiagramm in Fig. 4 zeigt einen sehr ähnlichen Ablauf wie das Zeitdiagramm in Fig. 3, wobei aber anstelle des Steuertaktes SIR-CL im Wartungs- und Bedienungsprozessor 6 oder einem angeschlossenen Tester der Steuertakt ST-CL erzeugt wird, der im Tester die Übernahme der jeweils nächsten (Ergebnis)-daten, in Fig. 4 in der untersten Zeile von oben mit NDO bezeichnet, steuert. Diese Ergebnisdaten stammen, wie in Fig. 4 die Beschriftung zur untersten Zeile zeigt, von den m Master-Flipflops 23 des Schnittstellenregisters und werden über den Systembus 8 übertragen. Das in Fig. 4 in der zweiten Zeile von unten dargestellte Signal, das über die Steuerleitung 17 übertragen wird, steuert die Bus-Senderschaltungen 18 in der Weise, dass sie bei Vorliegen dieses Signals die Ergebnisdaten über die Leitungen des Systembusses 8 übertragen.

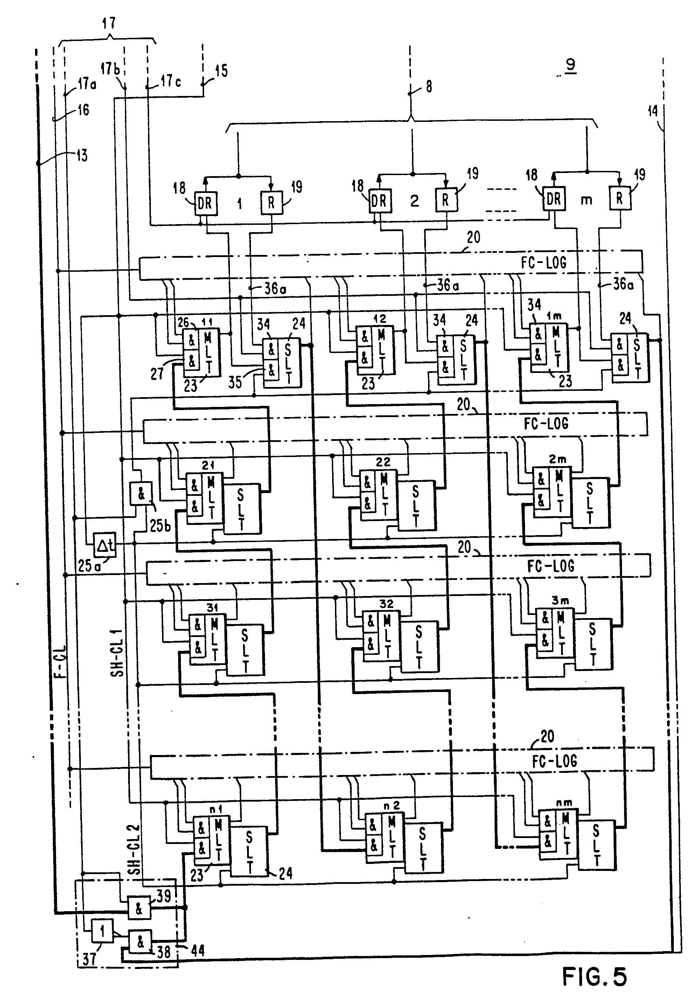

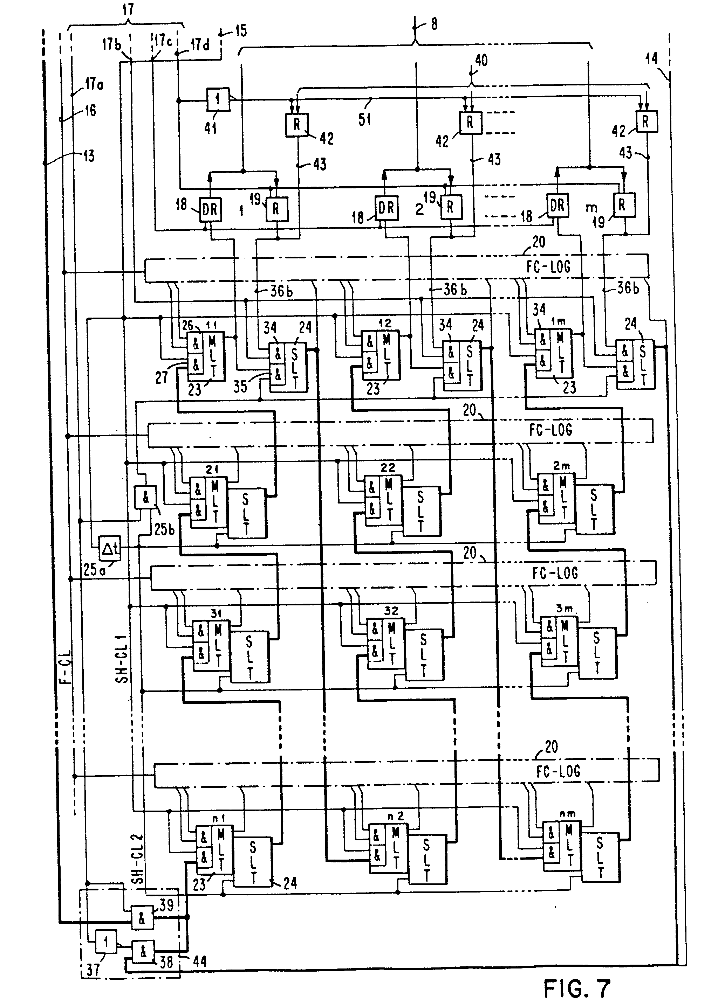

Die in Fig. 5 dargestellte Testeinrichtung des Prozessors 9 zeigt, wie durch Einführung einer zusätzlichen Eingangsstufe 34 an den Slave-Flipflops 24 der Schnittstellen-Registerstufen und durch die Verbindung dieses Eingangs über Empfangsleitungen 36a mit den Bus-Empfängerschaltungen 19 ein alternierender Betrieb für das Übertragen der Testdaten und der Ergebnisdaten eine 32fach höhere Geschwindigkeit, im Vergleich zur konventionellen Test- und Ergebnisdatenübertragung mittels LSSD-Schiebeketten, erreicht wird.

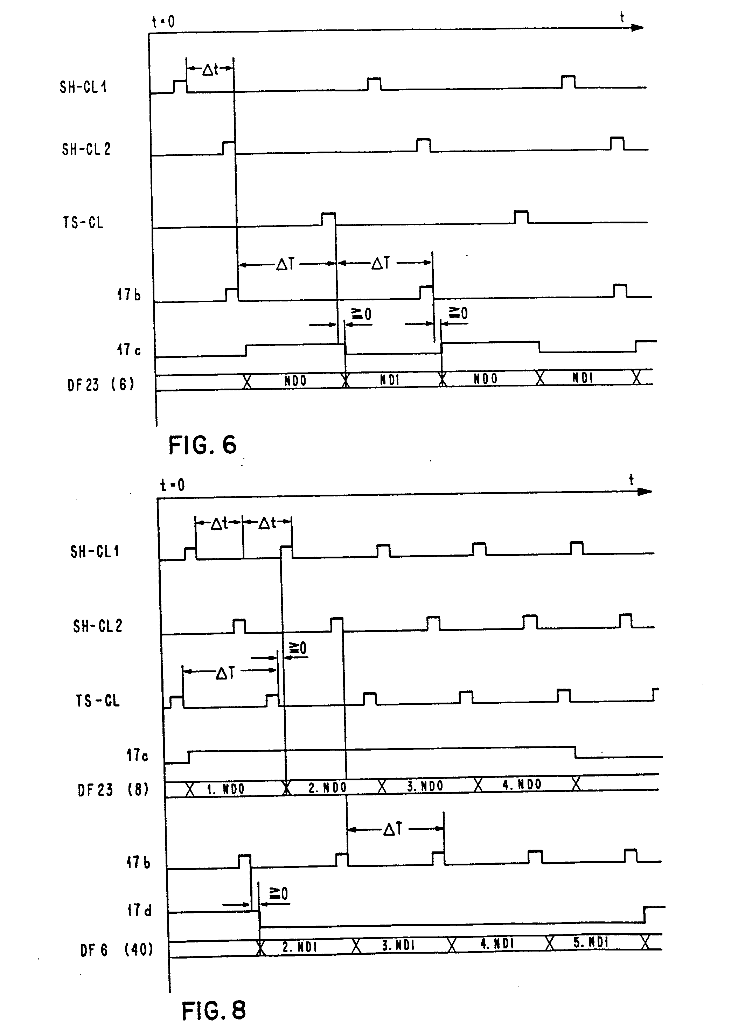

Fig. 6 zeigt das zugehörige Zeitdiagramm für diesen alternierenden Betrieb. Im Vergleich mit den Fign. 3 und 4 ist zu sehen, dass die Frequenz des Schiebetaktes SH-CL1 und SH-CL2 nur halb so gross ist. Dieses hat seine Ursache darin, dass die Geschwindigkeit der Datenübertragung über den zweiseitigen Systembus 8 konstant ist, und sich die Testdaten und die Ergebnisdaten die Benutzung dieses Systembusses untereinander teilen.

Das Steuersignal auf der Steuerleitung 17c, das die Bus-Senderschaltungen 18 aktiviert, hat im Gegensatz zu einer Datenübertragung in nur der Senderichtung vom Prozessorchip 9 zum Wartungs- und Bedienungsprozessor 6 hier einen alternierenden Verlauf (vgl. zweite Zeile von unten). Dies alternierende Verlauf spiegelt auch die Taktvehältnisse auf der Steuerleitung 17b wieder, da die Impulse dieses Taktes über die Eingangsstufe 34 des Slave-Flipflops 24 der Stufen des Schnittstellenregisters die Übernahme von Testdaten steuern. Dazu ist es allerdings notwendig, den Schiebetakt SH-CL23 für die Slave-Flipflops der Stufen der Schnittstellenregisters abzuschalten. Dies geschieht mit Hilfe der Torschaltung 25b, die im ringförmigen Girlanden-Testbetrieb durch ein Steuersignal, z.B. binär Null, auf der Steuerleitung 17a gesperrt wird, so dass die von dem Verzögerungsglied 25a erzeugten Schiebeimpulse SH-CL2 nicht weitergeleitet werden können. Die Übernahme der Ergebnisdaten im Wartungs- und Bedienungsprozessor 6 in dessen Eingangsregister (nicht dargestellt) erfolgt mit Hilfe des Taktes TS-CL.

Die Zeitdiagramme in den Fign. 3, 4, 6 und 8 zeigen, wie sowohl bei der Übernahme von Testdaten, als auch bei der Abgabe von Ergenbnisdaten die Schieberegisterstufen des Prozessors 9 mit Hilfe der Schiebetakte SH-CL1 und SH-CL2 weitergetaktet werden. In der Senderichtung, also bei der Übertragung der Ergebnisdaten, muss bei dem Übernahmetakt ST-CL im Wartungs- und Bedienungsprozessor 6 oder in einem angeschlossenen Tester die Laufzeit der Daten über den Systembus berücksichtigt werden, weshalb seine Zeitlage gegenüber dem Verschiebetakt SH-CL2 verzögert ist, wie die Fign. 4 und 6 erkennen lassen. In der Empfangsrichtung, also bei der Übertragung von Testdaten, können die Impulse des Steuertaktes SIR-CL, die über die Steuerleitung 17b übertragen werden, mit dem Verschiebetakt SH-CL2 zeitlich zusammenfallen.

Eine weitere Geschwindigkeitssteigerung um den Faktor 2 lässt sich erreichen, wenn der Systembus 8 im Testbetrieb als einseitiger, d.h. als einseitig gerichteter Bus verwendet wird. Im vorliegenden Ausführungsbeispiel dient er zu Übertragung der Ergebnisdaten. Da die Prozessorchips 9, 10, ... n, wie Fig. 7 zeigt, für Fabriktestzwecke ohnehin funktionelle Eingangsanschlüsse haben, kann der Eingangsbus 40, der diese Anschlüsse normalerweise mit dem Tester verbindet, auch dazu verwendet werden, eine Verbindung zum Wartungs- und Bedienungsprozessor 6 herzustellen, über die die Testdaten zum Prozessorchip 9 übertragen werden. Auf diese Weise lässt sich die Übertragung von Testdaten und Ergebnisdaten überlappen. Die Systembus-Empfängerschaltungen 19 und die Eingangsbus-Empfängerschaltungen 42 werden durch Signale auf der Steuerleitung 17d und der Steuerleitung 51 gesteuert, welche die invertierten Verhältnisse der Signale auf der Steuerleitung 17d wiederspiegelt, wofür der Inverter 41 verantwortlich ist.

Die Übertragung der Ergebnisdaten wird wiederum durch Steuersignale auf der Steuerleitung 17c gesteuert, welche die Bus-Senderschaltungen 18 aktivieren. Fig. 8 zeigt das zugehörige Zeitdiagramm, das die überlappte Übertragung von Testdaten NDI und Ergebnisdaten NDO sowie die dadurch mögliche Frequenzverdoppelung der Zeitsteuersignale in den Zeilen 1, 2, 3 und 5 erkennen lässt.

Im Fehlerfalle des Systembusses 8 oder der jeweiligen Bus-Sender- oder -empfängerschaltungen oder auch des Schnittstellenregisters im Wartungs- und Bedienungsprozessor 6 oder für spezielle Testzwecke werden die Testdaten über die Leitung 13 und den Schalter 44 in die girlandenförmige Schieberegisterkette eingegeben.

Durch ein Signal auf der Steuerleitung 17a wird im Schalter 44 das UND-Tor 39 für die Übertragung der Testdaten aktiviert und das UND-Tor 38 über den Inverter 37 deaktiviert.

Die Testdaten gelangen über das UND-Tor 39 mit Hilfe des über die Steuerleitung 15 übertragenen Schiebetaktes SH-CL1 und des auf dem Prozessorchip 9 selbst erzeugten Schiebetaktes SH-CL2 von Stufe zu Stufe in die Schieberegisterkette. Wenn diese Kette vollständig geladen ist, werden die Testdaten den jeweiligen Logik-Subnetzen 20 zugeführt. Die Reaktion dieser Logik-Subnetze 20 auf die Testdaten sind die Ergebnisdaten, die nun von den Logik-Subnetzen in die Stufen der Schieberegisterkette eingegeben werden. Von dort werden sie wieder mit Hilfe des Schiebetaktes über die Leitung 14, die ebenfalls eine einadrige Leitung ist, seriell in den Wartungs- und Bedienungsprozessor 6 zwecks Fehleranalyse und -diagnose übertragen. Auf diese Weise ist es möglich, die Prozessorlogik im Fehlerfalle zu prüfen und gegebenenfalls den gesamten Betrieb der Datenverarbeitungsanlage aufrechtzuerhalten, allerdings bei stark reduzierter Geschwindigkeit. Die letztgenannte Möglichkeit wird dort angewendet werden können, wo eine hohe Verfügbarkeit auf Kosten einer hohen Verarbeitungsgeschwindigkeit im Fehlerfalle wichtiger ist.

## Patentansprüche

1. Einrichtung zur Fehlerprüfung und -diagnose für eine elektronische Datenverarbeitungsanlage, bestehend aus mindestens einem Prozessor, einem Hauptspeicher und einem Wartungs- und Bedienungsprozessor oder Tester, die über einen schnellen Systembus miteinander verbunden sind, wobei ein serieller Prüfbus (13, 14) vorhanden ist, der Diagnoseinformation in die zu Schiebeketten zusammengeschalteten Speicherelemente aus dem Tester ein- bzw. in den Tester ausliest, welche den Logik-Subnetzen zugeordnet sind, um Testdaten in diese zu übertragen, bzw. Ergebnisdaten, die sich aus der Verabeitung der Testdaten ergeben, in den Tester zur Auswertung auszulesen, dadurch gekennzeichnet, dass die die Logik-Subnetze (20; Fign. 2, 5 und 7), die ein Prozessor (9) enthält, im normalen Betrieb verbindenden Speicherelemente (Master-Slave-Flipflops 23, 24) im Fehlerprüf- und -diagnosebetrieb zu einer girlandenförmigen Schieberegisterkette zusammenschaltbar sind, deren Anfang und Ende mittels eines steuerbaren Schalters (44) zusammenschaltbar sind, wobei auch die Speicherelemente, welche die Stufen (11, 12, ..., 1m), die das Schnittstellenregister bilden, das zwischen den Systembus (8) und die aus den Logik-Subnetzen (20) bestehende Prozessorlogik geschaltet ist und sowohl als Datenempfangs- als auch Senderegister dient, in die Schieberegisterkette einbezogen sind, so dass Testdaten vom Wartungs- und Bedienungsprozessor (6) parallel über den Systembus (8) in die Stufen des Schnittstellenregisters übertragen und von dort schrittweise über die girlandenförmige Schieberegisterkette in die Logik-Subetze eingegeben werden und dass nach erfolgter Prüfung deren Ergebnisdaten in die Schieberegisterkette eingegeben werden, von wo sie schrittweise zu den Stufen des Schnittstellenregisters und von dort über den Systembus (8) parallel zum Wartungs- und Bedienungsprozessor (6) zwecks Fehleranalyse und -diagnose gelangen.

2. Einrichtung nach Anspruch 1, dadurch gekennzeichnet, dass für eine alternierende Übertragung von Testdaten und Ergebnisdaten (vgl. Fig. 6) über den Systembus (8; Fig. 5) die Speicherelemente, welche die Stufen des Schnittstellenregisters bilden, aus solchen Master-Slave-Flipflops (23, 24) bestehen, bei denen die Slave-Flipflops (24) über eine zusätzliche Eingangsstufe (34) verfügen, die mit den Bus-Empfängerschaltungen (19) zum Empfang der Testdaten verbunden sind, wobei jeweils der andere Eingang der zusätzlichen Eingangsstufe (34) über eine Steuerleitung (17b) mit einem dem zweiten Verschiebetakt (SH-CL2) entsprechenden Takt beaufschlagt wird und wobei eine Torschaltung (25b) eine Übertragung der von einem Verzögerungsglied (25a) erzeugten Impulse des zweiten Verschiebetaktes (SH-CL2) zu den Slave-Flipflops (24) der Schnittstellen-Registerstufen sperrt und dass zur Abgabe der Ergebnisdaten aus den Master-Flipflops (23) der Schnittstellen-Registerstufen an den Systembus (8) mit Hilfe eines weiteren Steuersignals auf einer weiteren Steuerleitung (17c), die Bus-Senderschaltungen (18) aktiviert werden.

3. Einrichtung nach Anspruch 2, dadurch gekennzeichnet, dass für eine zeitlich überlappte Übertragung von Testdaten und Ergebnisdaten zwei Bussysteme (8, und 40; Fig. 7) vorgesehen sind, von denen die Testdaten über ein an sich für Fabriktestzwecke auf dem Prozessorchip (9) vorhandenes Eingangsbussystem (40), das mit dem Wartungs- und Bedienungsprozessor (6) oder einem Fabriktester verbunden ist, über separate Empfangsschaltungen (42) und Verbindungsleitungen (43 und 36b) zur jeweiligen Eingangsstufe (34) des Slave-Flipflops (24) der Schnittstellen-Registerstufen übertragen wird, wenn über eine Steuerleitung (17d) ein entsprechendes Signal anliegt, das, über einen Inverter (41) und eine Verbindungsleitung (51) zu den Empfängerschaltungen (42) geführt, diese aktiviert, wobei gleichzeitig die Bus-Senderschaltungen (19) von dem genannten Steuersignal, das über die Steuerleitung (17d) übertragen wird, deaktiviert werden und dass die Ergebnisdaten gemäss der in Anspruch 2 angegebenen Weise über den Systembus (8) zu dem Wartungs- und Bedienungsprozessor (6) oder Tester übertragen werden.

4. Einrichtung nach einem der Ansprüche 1 bis 3, dadurch gekennzeichnet, dass im Fehlerfall des Systembusses oder für spezielle Tests die Übertragung der Testdaten und Ergebnisdaten über einen Prüfbus (13, 14) erfolgt, der den Wartungs- und Bedienungsprozessor (6) bzw. Tester mit der zu prüfenden Einheit [beispielsweise Prozessor (9)] verbindet, wobei der Schalter (44) in eine Position eingestellt ist, in der die Ringverbindung zwischen der ersten und der letzten Stufe der girlandenförmigen Schieberegisterkette aufgetrennt ist.

5. Verfahren zum Betrieb der Einrichtung nach Anspruch 1, dadurch gekennzeichnet, dass die Übernahme der Testdaten aus dem Wartungs- und Bedienungsprozessor (6) über den Systembus (8) in die Master-Flipflops (23) der Schnittstellen-Registerstufen mit den Impulsen des Taktes (SIR-CL), der über eine Steuerleitung (17b) vom Wartungs- und Bedienungsprozessor übertragen wird, erfolgt, wobei die Testdatenübertragungen über den Systembus (8) mit den internen Verschiebeschritten (SH-CL1, SH-CL2) überlappt erfolgen und dass die nach jedem Prüfschritt entstandenen Ergebnisdaten von den Master-Flipflops (23) der Schnittstellen-Registerstufen über die Bus-Senderschaltungen (18) und den systembus (8) zum Wartungs- und Bedienungsprozessor (6) übertragen werden, wobei die Bus-Senderschaltungen für die Übertragung durch ein Steuersignal auf einer Steuerleitung (17c) aktiviert werden und wobei sich die Ergebnisdatenübertragungen ebenfalls mit den internen Verschiebeschritten überlappen.

6. Verfahren zum Betrieb einer Einrichtung nach Anspruch 2, dadurch gekennzeichnet, dass für eine alternierende Übertragung der Testdaten und der Ergebnisdaten die Taktsignale für die Übernahme der Testdaten bei gesperrtem zweiten Schiebesignal (SH-CL2) über eine separate Steuerleitung (17b), die mit dem Wartungs- und Bedienungsprozessor (6) oder einem Tester verbunden ist, an die Slave-Flipflops (24) der Schnittstellen-Registerstufen angelegt werden, während nach einer solchen Übernahme von Testdaten die Ergebnisdaten jeweils zwischen zwei Übernahmen von Testdaten aus den Master-Flipflops (23) der Schnittstellen-Registerstufen übertragen werden, wobei diese Übertragung durch ein Steuersignal auf einer Steuerleitung (17c), die ebenfalls mit dem Wartungs- und Bedienungsprozessor oder einem Tester verbunden ist, steuerbar ist, indem dieses Signal die Bus-Senderschaltungen (18) aktiviert, wobei die genannten Übertragungen von Testdaten und Ergebnisdaten intern mit den Verschiebeoperationen mit Hilfe der Impulse des ersten (SH-CL1) und des zweiten Schiebetaktes (SH-CL2) überlappt sind.

7. Verfahren zum Betrieb einer Einrichtung nach Anspruch 3, dadurch gekennzeichnet, dass für eine überlappte Übertragung von Testdaten und Ergebnisdaten die Testdaten über einen separaten Eingangsbus (40) übertragen werden, wobei diese Übertragung über separate Empfangsschaltungen (42) erfolgt, die von einem Steuersignal auf einer weiteren Steuerleitung (17d) aktiviert werden und wobei die Übernahme der Testdaten in den Master-Flipflops (24) durch Taktsignale auf einer Steuerleitung (17b), unter gleichzeitiger Sperrung der Taktsignale des zweiten Schiebetaktes (SH-CL2), erfolgt und gleichzeitig die Übertragung der Ergebnisdaten aus dem vorhergehenden Prüfschritt über den Systembus (8) erfolgt, wobei die internen Verschiebeschritte mit den Übertragungen überlappt sind.

## Claims

1. Error testing and diagnostic device for an electronic data processing system having at least one processor, one main storage and one maintenance and service processor or tester interconnected by a fast system bus, wherein a serial test bus (13, 14) is provided supplying diagnostic information read from and/or written into the tester to storage elements combined in the form of shift chains, said storage elements being associated with logic subsystems for transferring test data into said subsystems and/or for reading result data, obtained by processing test data, into the tester for evaluation, characterized in that the storage elements (master/slave flip-flops 23, 24), interconnecting the logic subsystems (20; Figs. 2, 5 and 7) contained in a processor (97 during normal operation, are linked in the error test and diagnostic mode in the form of a garland-shaped shift register chain, whose beginning and end are connected by a controllable switch (44), wherein the storage elements, forming the stages (11, 12, ..., 1m) of the interface register, connected between the system bus (8) and the processor logic made up of the logic subsystems (20) and which serves both as a data receiving and transmitting register, are included in the shift register chain, so that test data from the maintenance and service processor (6) are transmitted in parallel on the system bus (8) to the interface register stages where they are entered in steps, through the garland-shaped shift register chain, into the logic subsystems, and that upon completion of testing, the result data of said logic subsystems are entered into the shift register chain from where they are transferred in steps to the interface register and from there in parallel on the system bus (8) to the maintenance and service processor (6) for error analysis and diagnosis.

2. Device according to claim 1, characterized in that for alternatively transferring test and result data (cf. Fig. 6) on the system bus (8; Fig. 5), the storage elements, forming the stages of the interface register, are made up of such master/slave flip-flops (23, 24) whose slave flip-flops (24) comprise an additional input stage (34) which is connected to the bus receiver circuits (19) for receiving the test data, wherein a clock corresponding to the second shift clock (SH-CL2) is applied through a control line (17b) to the respective other input of the additional input stage (34), and wherein the pulses of the second shift clock (SH-CL2), generated by a delay means (25a), are blocked by a gate circuit (25b) so that they cannot be transferred to the slave flip-flops (24) of the interface register stages, and that for the supply of the result data from the master flip-flops (23) of the interface register stages to the system bus (8), the bus transmitter circuits (18) are activated with the aid of a further control signal on a further control line (17c).

3. Device according to claim 2, characterized in that for the time-overlapped transfer of test and result data, two bus systems (8 and 40; Fig. 7) are provided transferring the test data through an input bus system (40), existing on the processor chip (9) for factory test purposes and connected to the maintenance and service processor (6) or a factory tester, and through separate receiver circuits (42) as well as through connecting lines (43 and 36b) to the respective input stage (34) of the slave flip-flop (24) of the interface register stages in response to a corresponding signal applied by a control line (17d), said signal being fed through an inverter (41) and a connecting line (51) to the receiver circuits (42), activating the latter, wherein said control signal, transferred on the control line (17d), simultaneously deactivates the bus transmitter circuits 619), and that the result data are fed on the system bus (8) in the manner according to claim 2 to the maintenance and service processor (6) or the tester.

4. Device according to any one of the claims 1 to 3, characterized in that in the event of an error of the system bus or for special tests, the test and result data are transferred on a test bus (13, 14) connecting the maintenance and service processor (6) and the tester, respectively, to the unit to be tested [say, processor (9)], wherein the switch (44) is set to a position in which the ring connection between the first and the last stage of the garland-shaped shift register stage is interrupted.

5. Method for operating the device according to claim 1, characterized in that the entry of test data from the maintenance and service processor (6) through the system bus (8) into the master flip-flops (23) of the interface register stages is effected by the pulses of the clock (SIR-CL) transferred from the maintenance and service processor on a control line (17b), wherein the test data transfers on the system bus (8) and the internal shift steps (SH-CL1, SH-CL2) are overlapping, and that the result data accrued after each test are transferred from the master flip-flops (23) of the interface register stages through the bus transmitter circuits (18) and the system bus (8) to the maintenance and service processor (6), wherein the bus transmitter circuits are activated for said transfers by a control signal on a control line (17c), and wherein the result data transfers and the internal sfift steps are also overlapping.

6. Method for operating a device according to claim 2, characterized in that for alternately transferring test and result data, the clock signals for the entry of the test data in the event of a blocked second shift signal (SH-CL2) are applied to the slave flip-flops (24) of the interface register stages through a separate control line (17b) connected to the maintenance and service processor (6) or a tester, whereas after such a test data entry, the result data are in each case transferred from the master flip-flops (23) of the interface register stages between two such test data entries, wherein said transfer is controlled by a control signal on control line (17c), also connected to the maintenance and service processor or a tester, in that said signal activates the bus transmitter circuits (18), said test and result data transfers being made to internally overlap the shift operations in response to pulses of the first (SH-CL1) and the second shift clock (SH-CL2).

7. Method for operating a device according to claim 3, characterized in that for an overlapped transfer of test and result data, the test data are transferred on a separate input bus (40), wherein said transfer is effected through separate receiver circuits (42) activated by a control signal on a further control line (17d), and wherein the test data in the master flip-flops (24) are transferred in response to clock signals on a control line (17b), while the clock signals of the second shift clock (SH-CL2) are simultaneously blocked and the result data from the preceding test step are transferred on the system bus (8), with the internal shift steps and the transfers overlapping one another.

**Revendications**

1. Dispositif pour le contrôle et le diagnostic de défaut pour une installation électronique de traitement des données, constitué par au moins un processeur une mémoire principale et un processeur de maintenance et de service ou une unité de contrôle, qui sont reliés entre eux par l'intermédiaire d'un bus rapide de système, et dans lequel il est prévu un bus de contrôle serie (13, 14), qui introduit une information de diagnostic depuis l'unité de contrôle dans les éléments de mémoire interconnectés pour former des chaînes de décalage ou qui introduit cette information dans l'unité de contrôle en la lisant à partir des éléments de mémoire qui sont associés à des réseaux logiques secondaires, afin de transmettre dans ces derniers des données de contrôle ou bien pour lire des données de résultat, qui sont obtenues à partir du traitement des données de contrôle, pour les introduire dans les unités de contrôle en vue d'une évaluation, caractérisé en ce que les éléments de mémoire (bascules bistables maître-esclave 23, 24), qui relient pendant le fonctionnement normal les réseaux logiques secondaires (20; figures 2, 5 et 7), qui contiennent un processeur (9), peuvent être interconnectés pendant le fonctionnement de contrôle et de diagnostic de défauts, pour former une chaîne de registres à décalage en forme de guirlande, dont le début et la fin peuvent être interconnectés au moyen d'un commutateur commandable (44), auquel cas les éléments de mémoire, qui forment les étages (11, 12, ..., 1m) constituant le registre d'interface, qui est branché entre le bus de système (8) et la logique à processeur constituée par les réseaux logiques secondaires (20), et sert aussi bien de registre de réception de données que de registre d'émission de données, sont insérés dans la chaîne de registres à décalage de sorte que les données de contrôle délivrées par le processeur de maintenance et de service (6) sont transmises an parallèle par l'intermédiaire du bus de système (8) dans les étages du registre d'interface et sont insérés pas-à-pas, à partir de là, au moyen de la chaîne de registres à décalage en forme de guirlande, dans les réseaux logiques secondaires, et qu'une fois le contrôle exécuté, leurs données de résultat sont introduites dans la chaîne de registres à décalage, d'où elles parviennent pas-à-pas aux étages du registre d'interface et à partir de là, par l'intermédiaire du bus se système (8), en parallèle avec le processeur de maintenance et de service (6), en vue de la réalisation d'une analyse d'un diagnostic de défauts.

2. Dispositif suivant la revendication 1, caractérisé par le fait que pour une transmission alternée de données de contrôle et de données de résultat (voir figure 6) par l'intermédiaire du bus de système (8; figure 5), les éléments de mémoire, qui forment les étapes du registre d'interface, sont constitués par des bascules bistables maître-esclave (23, 24), dans lesquelles les bascules bistables esclaves (24) disposent d'étages d'entrée respectifs supplémentaires (34), qui sont reliés aux circuits de réception (19) du bus, servant à recevoir les données de contrôle, auquel cas respectivement l'autre entrée de l'étage d'entrée supplémentaire (34) est chargée par l'intermédiaire d'une ligne de commande (17b), à une cadence correspondant à la seconde cadence de transfert (SH-CL2), et un circuit de porte (25b) bloque une transmission des impulsions, produites par un circuit de retard (25a), de la seconde cadence de décalage (SH-CL2) en direction des bascules bistables esclaves (24) des étages du registre d'interface, et que pour la délivrance des données de résultat à partir des bascules bistables maîtres (23) des étages du registre d'interface au bus de système (8), les circuits d'émission (18) du bus sont activés au moyen d'un autre signal de commande présent dans une autre ligne de commande (17c).

3. Dispositif selon la revendication 2, caractérisé en ce que pour une transmission imbriquée dans le temps de données de contrôle et de données de résultat, il est prévu deux systèmes de bus (8 et 40; figure 7) au moyen desquels les données de contrôle sont transmises par l'intermédiaire d'un système de bus d'entrée (40), qui est présent à des fins de contrôle de fabrication sur la plaquette (9) du processeur et qui est relié au processeur de maintenance et de service (6) ou à une unité de contrôle de fabrication, par l'intermédiaire de circuits de réception séparés (42) et de lignes de liaison (43 et 36b) à l'étage d'entrée respectif (34) de la bascule bistable esclave (24) des étages du registre d'interface , lorsque se trouve appliqué, par l'intermédiaire d'une ligne de commande (17d), un signal correspondant qui, en étant envoyé par l'intermédiaire d'un inverseur (41) ou d'une ligne de liaison (51) aux circuits de réception (42), active ces derniers, auquel cas simultanément les circuits d'émission (19) du bus sont désactivés par ledit signal de commande qui est transmis par l'intermédiaire de la ligne de commande (17a), et que les données de résultat sont transmises de la manière indiquée dans la revendication 2, par l'intermédiaire du bus de système (8) au processeur de maintenance et de service (6) ou à l'unité de contrôle.

4. Dispositif selon l'une des revendications 1 à 3, caractérisé en ce que, dans le cas d'un défaut du bus du système ou bien pour des contrôles particuliers, la transmission des données de contrôle et des données de résultat s'effectue par l'intermédiaire d'un bus de contrôle (13, 14), qui relie le processeur de maintenance et de service (6) ou l'unité de contrôle à l'unité à contrôler [par exemple le processeur (9)], auquel cas le commutateur (44) est réglé dans une position dans laquelle la liaison annulaire est interrompue entre le premier et le dernier étages de la chaîne de registres à décalage en forme de guirlande.

5. Procédé pour faire fonctionner le dispositif selon la revendication 1, caractérisé en ce que le transfert des données de contrôle à partir du processeur de maintenance et de service (6) par l'intermédiaire du bus (8) du système, dans les bascules bistables maîtres (23) des étages du registre d'interface s'effectue à l'aide des impulsions de la cadence (SIR-CL), qui est transmise par l'intermédiaire d'une ligne de commande (17b) à partir du processeur de maintenance et de service, auquel cas les transmissions des données de contrôle s'effectuent par l'intermédiaire du bus (8) du système en étant imbriquées avec les pas de décalage internes (SH-CL1, SH-CL2) et que les données de résultat, qui apparaissent après chaque pas de contrôle, sont transmises aux bascules bistabiles maîtres (23) des étages du registre d'interface par l'intermédiaire des circuits d'émission (18) du bus et du bus (8) du système au processeur de maintenance et de service (6), auquel cas les circuits d'émission du bus sont activés pour la transmission par un signal de commande présent dans une ligne de commande (17c) et les transmissions des données de résultat sont également en chevauchement avec les pas de décalage internes.

6. procédé pour faire fonctionner un dispositif suivant la revendication 2, caractérisé par le fait que pour une transmission alternée des données de contrôle et des données de résultat, les signaux de cadence pour le transfert des données de contrôle lorsque le second signal de décalage (SH-CL2) est bloqué, sont appliqués aux bascules bistables esclaves (24) des étages du registre d'interface, par l'intermédiaire d'une ligne de commande séparée (17b), qui est reliée au processeur de maintenance et de service (6) ou à une unité de contrôle, tandis qu'après un tel transfert de données de contrôle, les données de résultat sont transmises respectivement entre deux transferts de données de contrôle à partir des bascules bistables maîtres (23) des étages du registre d'interface, auquel cas cette transmission peut être commandée par un signal de commande présent dans une ligne de commande (17c) qui est également reliée au processeur de maintenance et de service ou à une unité de contrôle, par le fait que ce signal active les circuits d'émission (18) du bus, auquel cas les transmissions indiquées de données de contrôle et de données de résultat sont, de façon interne, en chevauchement avec les opérations de décalage effectuées au moyen des impulsions de la première cadence de transfert (SH-CL1) et de la seconde cadence de transfert (SH-CL2).

7. Procédé pour faire fonctionner un dispositif suivant la revendication 3, caractérisé par le fait que pour une transmission imbriquée de données de contrôle et de données de résultat, les données de contrôle sont transmises par l'intermédiaire d'un bus d'entrée séparé (40), auquel cas cette transmission s'effectue par l'intermédiaire de circuits de réception séparés (42), qui sont activés par un signal de commande présent dans une autre ligne de commande (17a), et le transfert des données de contrôle dans les bascules bistabiles maîtres (24) est réalisé par des signaux de cadence présents dans une ligne de commande (17b), moyennant le blocage simultané des signaux de la seconde cadence de transfert (SH-CL2), et simultanément la transmission des données de résultat et à partir du pas de contrôle précédent est réalisée par l'intermédiaire du bus (8) du système, les pas internes de décalage étant imbriqués avec les transmissions.

FIG.1

FIG. 2

FIG. 3

FIG. 4

FIG. 5

FIG. 7

0 146 645

FIG. 6

FIG. 8

21